(19) Europäisches Patentamt
European Patent Office
Office européen des brevets

(11) **EP 4 600 737 A2**

(12) **EUROPEAN PATENT APPLICATION**

(43) Date of publication:
**13.08.2025   Bulletin 2025/33**

(21) Application number: **25166452.0**

(22) Date of filing: **26.03.2025**

(51) International Patent Classification (IPC):
***G03F 7/00*** *(2006.01)*

(52) Cooperative Patent Classification (CPC):
**G03F 7/70683**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **ASML Netherlands B.V.**
**5500 AH Veldhoven (NL)**

(72) Inventors:
• **EURLINGS, Markus, Franciscus, Antonius**
**5500 AH Veldhoven (NL)**
• **VERSTRAETEN, Bert**
**5500 AH Veldhoven (NL)**

(74) Representative: **ASML Netherlands B.V.**
**Corporate Intellectual Property**
**P.O. Box 324**
**5500 AH Veldhoven (NL)**

(54) **A SUBSTRATE, LITHOGRAPHIC METHOD AND METROLOGY METHOD**

(57)     Disclosed is a substrate, associated patterning device and metrology method. The substrate comprises one or more first metrology targets for measuring a parameter of interest in one or more measurement directions, each said one or more first metrology targets comprising at least one first-type sub-target and at least one second-type sub-target; and one or more second metrology targets, wherein each said second metrology target is similar to each said first metrology target, but with the first-type sub-targets swapped in position with the second-type sub-targets of the same measurement direction for at least one measurement direction of said one or more measurement directions.

Fig. 6

EP 4 600 737 A2

**Description**

FIELD OF THE INVENTION

The present invention relates to a target arrangement for metrology of a lithographic process and to a method to measure a parameter of a lithographic process.

BACKGROUND ART

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g., including part of, one, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. In lithographic processes, it is desirable frequently to make measurements of the structures created, e.g., for process control and verification. Various tools for making such measurements are known, including scanning electron microscopes, which are often used to measure critical dimension (CD), and specialized tools to measure overlay, a measure of the accuracy of alignment of two layers in a device. Overlay may be described in terms of the degree of misalignment between the two layers, for example reference to a measured overlay of 1 nm may describe a situation where two layers are misaligned by 1 nm.

Recently, various forms of scatterometers have been developed for use in the lithographic field. These devices direct a beam of radiation onto a target and measure one or more properties of the scattered radiation - e.g., intensity at a single angle of reflection as a function of wavelength; intensity at one or more wavelengths as a function of reflected angle; or polarization as a function of reflected angle - to obtain a "spectrum" from which a property of interest of the target can be determined. Determination of the property of interest may be performed by various techniques: e.g., reconstruction of the target by iterative approaches such as rigorous coupled wave analysis or finite element methods; library searches; and principal component analysis.

The targets used by conventional scatterometers are relatively large, e.g., gratings of $40\mu m$ by $40\mu m$ and the measurement beam generates a spot that is smaller than the grating (i.e., the grating is underfilled). This simplifies mathematical reconstruction of the target as it can be regarded as infinite. However, in order to reduce the size of the targets, e.g., to $10\mu m$ by $10\mu m$ or less, e.g., so they can be positioned in amongst product features, rather than in the scribe lane, metrology has been proposed in which the grating is made smaller than the measurement spot (i.e., the grating is overfilled). Typically such targets are measured using dark-field scatterometry in which the zeroth order of diffraction (corresponding to a specular reflection) is blocked, and only higher orders processed. Examples of dark-field metrology can be found in international patent applications WO 2009/078708 and WO 2009/106279 which documents are hereby incorporated by reference in their entirety. Further developments of the technique have been described in patent publications US20110027704A, US20110043791A and US20120242970A. Modifications of the apparatus to improve throughput are described in US2010201963A1 and US2011102753A1. The contents of all these applications are also incorporated herein by reference. Diffraction-based overlay using dark-field detection of the diffraction orders enables overlay measurements on smaller targets. These targets can be smaller than the illumination spot and may be surrounded by product structures on a wafer. Targets can comprise multiple gratings which can be measured in one image.

In the known metrology technique, measurement results are obtained by measuring a metrology target to obtain the -1 and the +1 diffraction order intensities. The intensity asymmetry, a comparison of these diffraction order intensities, in the metrology target can be used as an indicator of the parameter of interest (e.g., overlay, dose or focus), where overlay describes an undesired misalignment of two layers, and focus and dose describe the focus and dose of the exposure when exposing the metrology target.

For the known methods, the metrology measurements may be adversely affected by the metrology apparatus, for example the effect of measurement field or "spot" inhomogeneity (i.e., imperfect spot homogeneity). This measurement field inhomogeneity results in measured intensity values from the image having a measurement field location dependence, which negatively impacts the inferred parameter of interest values.

SUMMARY OF THE INVENTION

It would be desirable to be able to perform metrology of a lithographic process with correction for the effect of measurement field (spot) inhomogeneity.

The invention in a first aspect provides a substrate comprising: one or more first metrology targets for measuring a parameter of interest in one or more measurement directions, each said one or more first metrology targets comprising at least one first-type sub-target and at least one second-type sub-target; and one or more second metrology targets, wherein each said second metrology target is similar to each said first metrology target, but with the first-type sub-targets swapped in position with the second-type sub-targets of the same measurement direction for at least one measurement direction of said one or more measurement directions.

The invention in a second aspect provides at least one patterning device for forming the substrate of the first aspect.

The invention in a third aspect provides a metrology method comprising: obtaining metrology data relating to a substrate comprising one or more first metrology targets for measuring a parameter of interest in one or more measurement directions, each said one or more first metrology targets comprising at least one first-type sub-target and at least one second-type sub-target; and one or more second metrology targets, wherein each said second metrology target is similar to each said first metrology target, but with the first-type sub-targets swapped in position with the second-type sub-targets of the same measurement direction for at least one measurement direction of said one or more measurement directions, said metrology data comprising first metrology data from said one or more first metrology targets and second metrology data from said one or more second metrology targets; and determining a parameter of interest from the metrology data; wherein said determining a parameter of interest comprises correcting said parameter of interest from an effect of measurement field inhomogeneity from a comparison and/or combination of one or more first measured values comprised within the first metrology data and one or more second measured values comprised within the second metrology data.

Further features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

BRIEF DESCRIPTION OF THE DRAWINGS

Embodiments of the invention will now be described, by way of example only, with reference to the accompanying drawings in which:

Figure 1 depicts a lithographic apparatus according to an embodiment of the invention;
Figure 2 depicts a lithographic cell or cluster according to an embodiment of the invention;
Figure 3 comprises (a) a schematic diagram of an inspection apparatus according to a first embodiment of the invention, (b) representation of a substrate and target in a first orientation, (c) representation of the substrate and target in a second orientation, (d) schematic illustration of the capture of a +1 diffraction order with a substrate in the first orientation (e) and schematic illustration of capture of a -1 diffraction order with the substrate in the second orientation;
Figure 4 depicts a known form of a multiple grating target and an outline of a measurement spot on a substrate;
Figure 5 depicts an image of the target of Figure 4 obtained in the inspection apparatus of Figure 3(a);
Figure 6 depicts examples of target arrangements according to embodiments of the invention; and
Figure 7 depicts (a) an example sampling scheme, and (b) to (e) sampling schemes according to different examples disclosed herein.

DETAILED DESCRIPTION OF EXEMPLARY EMBODIMENTS

Before describing embodiments of the invention in detail, it is instructive to present an example environment in which embodiments of the present invention may be implemented.

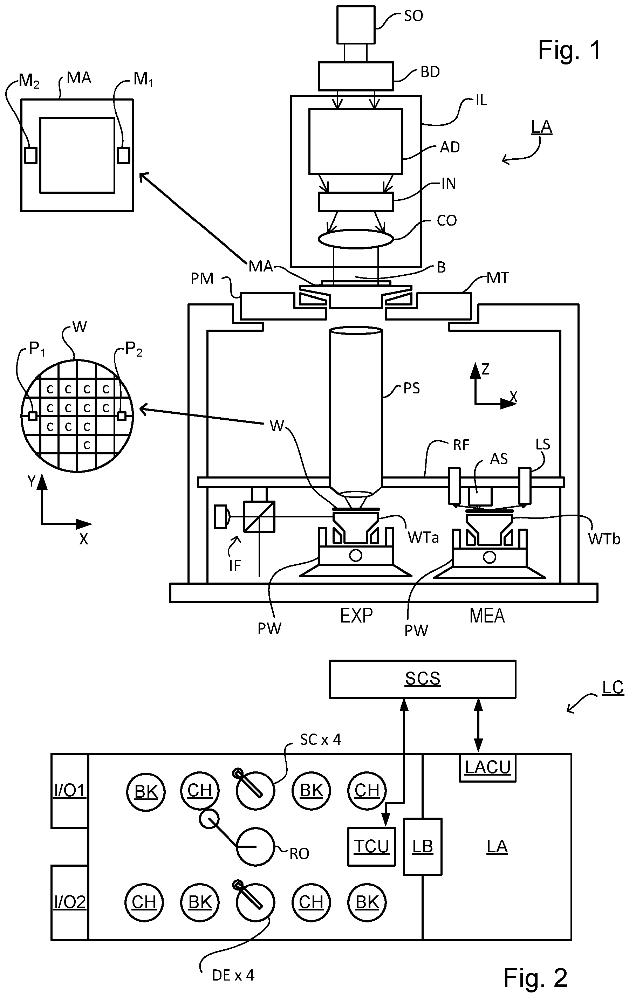

Figure 1 schematically depicts a lithographic apparatus LA. The apparatus includes an illumination optical system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; a substrate table (e.g., a wafer table) WTa, WTb constructed to hold a substrate (e.g., a resist coated wafer) W and connected to a second positioner PW configured to accurately position the substrate in accordance with certain parameters; and a projection optical system (e.g., a refractive projection lens system) PS configured to project a pattern imparted to the radiation beam B by patterning device MA onto a target portion C (e.g., including one or more dies) of the substrate W.

The illumination optical system may include various types of optical or non-optical components, such as refractive, reflective, magnetic, electromagnetic, electrostatic or other types of components, or any combination thereof, for directing, shaping, or controlling radiation.

The patterning device support holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support may be a frame or a table, for example, which may be fixed or movable as required. The patterning device support may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam, which is reflected by the mirror matrix.

As here depicted, the apparatus is of a transmissive type (e.g., employing a transmissive mask). Alternatively, the apparatus may be of a reflective type (e.g., employing a programmable mirror array of a type as referred to above, or employing a reflective mask).

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

Referring to Figure 1, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may include an adjuster AD for adjusting the angular intensity distribution of the radiation beam. Generally, at least the outer and/or inner radial extent (commonly referred to as $\sigma$-outer and $\sigma$-inner, respectively) of the intensity distribution in a pupil plane of the illuminator can be adjusted. In addition, the illuminator IL may include various other components, such as an integrator IN and a condenser CO. The illuminator may be used to condition the radiation beam, to have a desired uniformity and intensity distribution in its cross section.

The radiation beam B is incident on the patterning device (e.g., mask) MA, which is held on the patterning device support (e.g., mask table MT), and is patterned by the patterning device. Having traversed the patterning device (e.g., mask) MA, the radiation beam B passes through the projection optical system PS, which focuses the beam onto a target portion C of the substrate W, thereby projecting an image of the pattern on the target portion C. With the aid of the second positioner PW and position sensor IF (e.g., an interferometric device, linear encoder, 2-D encoder or capacitive sensor), the substrate table WTa, WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

Patterning device (e.g., mask) MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment markers may also be included within dies, in amongst the device features, in which case it is desirable that the markers be as small as possible and not require any different imaging or process conditions than adjacent features. The alignment system, which detects the alignment markers is described further below.

Lithographic apparatus LA in this example is of a so-called dual stage type which has two substrate tables WTa, WTb and two stations - an exposure station and a measurement station - between which the substrate tables can be exchanged. While one substrate on one substrate table is being exposed at the exposure station, another substrate can be loaded onto the other substrate table at the measurement station and various preparatory steps carried out. The preparatory steps may include mapping the surface control of the substrate using a level sensor LS and measuring the position of alignment markers on the substrate using an alignment sensor AS. This enables a substantial increase in the throughput of the apparatus.

The depicted apparatus can be used in a variety of modes, including for example a step mode or a scan mode. The construction and operation of lithographic apparatus is well known to those skilled in the art and need not be described further for an understanding of the present invention.

As shown in Figure 2, the lithographic apparatus LA forms part of a lithographic system, referred to as a lithographic cell LC or a lithocell or cluster. The lithographic cell LC may also include apparatus to perform pre- and post-exposure processes on a substrate. Conventionally these include spin coaters SC to deposit resist layers, developers DE to develop exposed resist, chill plates CH and bake plates BK. A substrate handler, or robot, RO picks up substrates from input/output ports I/O1, I/O2, moves them between the different process apparatus and delivers then to the loading bay LB of the lithographic apparatus. These devices, which are often collectively referred to as the track, are under the control of a track control unit TCU which is itself controlled by the supervisory control system SCS, which also controls the lithographic apparatus via lithography control unit LACU. Thus, the different apparatus can be operated to maximize throughput and processing efficiency.

In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly a manufacturing facility in which lithocell LC is located also includes metrology system MET (not shown) which receives some or all of the substrates W that have been processed in the lithocell. Metrology results are provided directly or indirectly to the supervisory control system SCS. If errors are detected, adjustments may be made to exposures of subsequent substrates, especially if the inspection can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

Within metrology system MET, an inspection apparatus is used to determine the properties of the substrates, and in particular, how the properties of different substrates or different layers of the same substrate vary from layer to layer. The inspection apparatus (not shown) may be integrated into the lithographic apparatus LA or the lithocell LC or may be a stand-alone device. To enable most rapid measurements, it is desirable that the inspection apparatus measure properties in the exposed resist layer immediately after the exposure. However, the latent image in the resist has a very low contrast - there is only a very small difference in refractive index between the parts of the resist which have been exposed to radiation and those which have not - and not all inspection apparatuses have sufficient sensitivity to make useful measurements of the latent image. Therefore measurements may be taken after the post-exposure bake step (PEB) which is customarily the first step carried out on exposed substrates and increases the contrast between exposed and unexposed parts of the resist. At this stage, the image in the resist may be referred to as semi-latent. It is also possible to make measurements of the developed resist image - at which point either the exposed or unexposed parts of the resist have been removed - or after a pattern transfer step such as etching. The latter possibility limits the possibilities for rework of faulty substrates but may still provide useful information.

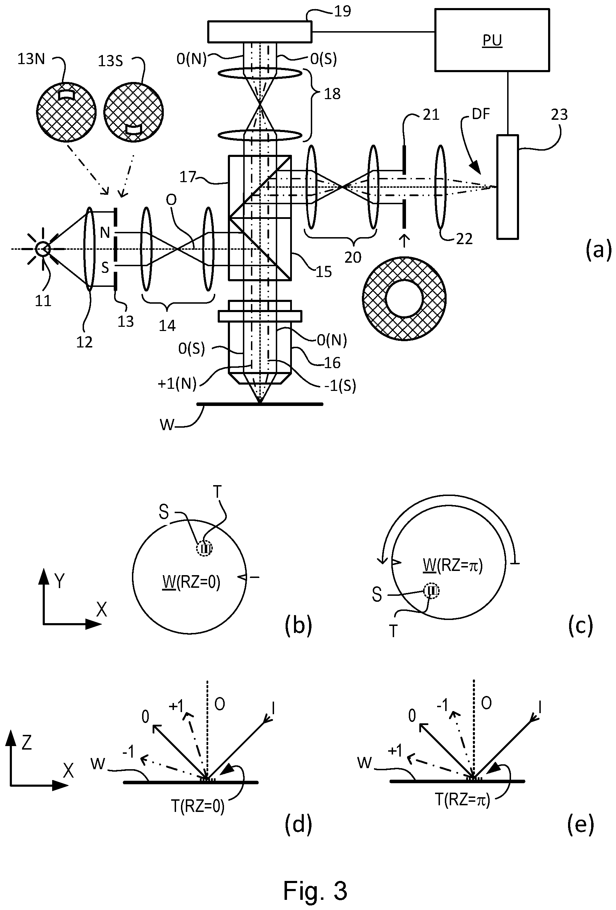

A metrology apparatus is shown in Figure 3(a). A target T and diffracted rays of measurement radiation used to illuminate the target are illustrated in more detail in Figures 3(b), 3(c), 3(d), 3(e). The metrology apparatus illustrated is of a type known as a dark-field metrology apparatus. The metrology apparatus depicted here is purely exemplary, to provide an explanation of dark-field metrology. The metrology apparatus may be a stand-alone device or incorporated in either the lithographic apparatus LA, e.g., at the measurement station, or the lithographic cell LC (as shown in Fig. 2). An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

In Figure 3(b), we see an example target T brought into measurement field S in a first orientation, which we can define by a rotation angle RZ of zero degrees (RZ=0). In Figure 3(c) we see the same target T brought into measurement field S with a rotation of 180 degrees (RZ=$\pi$ in radians). It will be understood that the sizes of measurement field and target here are greatly exaggerated for the sake of illustration. A real substrate may have many targets distributed across it, for measuring overlay and other parameters at different positions on the substrate. The diameter of measurement field S may be for example between 10 and 50 $\mu$m, while the target T fits within the measurement field diameter in this type of small target metrology. The target is thus referred to as "overfilled".

Figures 3 (d) and 3(e) show schematically more detail of the diffraction spectrum that results when a periodic structure (grating) of target T is placed into measurement field S with substrate W normal to the optical axis O of objective lens 16, for the measurement examples of Figure 3(b) and 3(c) respectively. In Figure 3(d) the orientation RZ=0 is used, while in Figure 3(e) the 180 degree rotated orientation is used (RZ=$\pi$). In each case, target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). The two first order rays are reversed for each of the two wafer rotations. It should be remembered that with an overfilled small target, these rays are just one of many parallel rays covering the area of the substrate including metrology target T and other features. Since the aperture in plate 13 has a finite width (necessary to admit a useful quantity of light), the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 3(a), 3(d) and 3(e) are shown somewhat off axis, purely to enable them to be more easily distinguished in the diagram.

At least the 0 and +1/-1 orders diffracted by the target T on substrate W are collected by objective lens 16 and directed back through beam splitter 15. Returning to Figure 3(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled -1(S)) are the ones which enter the lens 16.

A second beam splitter 17 divides the diffracted beams into two measurement branches. In a first measurement branch, optical system 18 forms a diffraction spectrum (pupil plane image) of the target T on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented.

As such, the particular forms of aperture plate 13 and field stop 21 shown in Figure 3(a) are purely examples. In another embodiment of the invention, on-axis illumination of the targets is used and an aperture stop with an off-axis aperture is used to pass substantially only one first order of diffracted light to the sensor. In other examples, a two quadrant aperture may be used. This may enable simultaneous detection of plus and minus orders, as described in US2010201963A1, mentioned above. Embodiments with optical wedges (segmented prisms or other suitable elements) in the detection branch can be used to separate the orders for imaging spatially in a single image, as described in US2011102753A1, mentioned above. In yet other embodiments, 2nd, 3rd and higher order beams (not shown in Figure 3) can be used in measurements, instead of or in addition to the first order beams. In yet other embodiments, a segmented prism can be used in place of aperture stop 21, enabling both +1 and -1 orders to be captured simultaneously at spatially separate locations on image sensor 23.

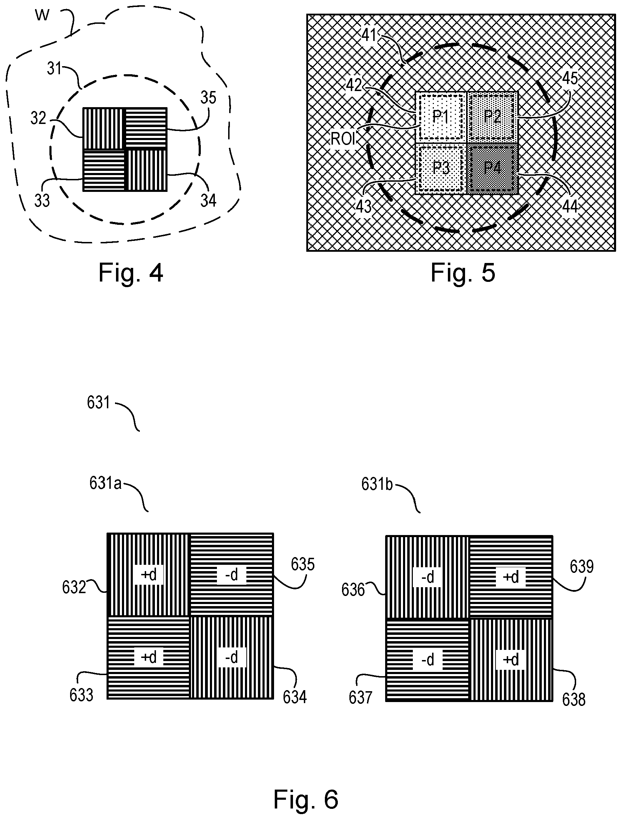

Figure 4 depicts an overlay target or composite overlay target formed on a substrate according to known practice. The overlay target in this example comprises four sub-targets (e.g., gratings) 32 to 35 positioned closely together so that they will all be within a measurement spot 31 formed by the illumination beam of the metrology apparatus. The four sub-overlay targets thus are all simultaneously illuminated and simultaneously imaged on sensor 23. In an example dedicated to measurement of overlay, sub-targets 32 to 35 are themselves composite structures formed by overlying gratings that are patterned in different layers of the semiconductor device formed on substrate W. Sub-targets 32 to 35 may have differently biased overlay offsets in order to facilitate measurement of overlay between the layers in which the different parts of the composite sub-targets are formed. Sub-targets 32 to 35 may also differ in their orientation, as shown, so as to diffract incoming radiation in X and Y directions. In one example, sub-targets 32 and 34 are X-direction sub-targets with biases of the +d, -d, respectively. Sub-targets 33 and 35 are Y-direction sub-targets with offsets +d and -d respectively. Separate images of these sub-targets can be identified in the image captured by sensor 23. This is only one example of an overlay target. An overlay target may comprise more or fewer than 4 sub-targets.

Figure 5 shows an example of an image that may be formed on and detected by the sensor 23, using the overlay target of Figure 4 in the apparatus of Figure 3. While the pupil plane image sensor 19 cannot resolve the different individual sub-targets 32 to 35, the image sensor 23 can do so. The hatched area 40 represents the field of the image on the sensor, within which the illuminated spot 31 on the substrate is imaged into a corresponding circular area 41. Within this, rectangular areas 42-45 represent the images of the small overlay target sub-targets 32 to 35. If the overlay targets are located in product areas, product features may also be visible in the periphery of this image field. Image processor and controller PU processes these images using pattern recognition to identify the separate images 42 to 45 of sub-targets 32 to 35. In this way, the images do not have to be aligned very precisely at a specific location within the sensor frame, which greatly improves throughput of the measuring apparatus as a whole.

Once the separate images of the overlay targets have been identified, the intensities of those individual images can be measured, e.g., by averaging or summing selected pixel intensity values within the identified areas. Intensities and/or other properties of the images can be compared with one another. These results can be combined to measure different parameters of the lithographic process. Overlay performance is an important example of such a parameter.

Using for example the method described in applications such as US20110027704A, mentioned above, overlay error (i.e., undesired and unintentional overlay misalignment) between the two layers within the sub-targets 32 to 35 is measured. Such a method may be referred to as micro diffraction based overlay (μDBO). This measurement may be done through overlay target asymmetry, as revealed by comparing their intensities in the +1 order and -1 order dark-field images (the intensities of other corresponding higher orders can be compared, e.g. +2 and -2 orders) to obtain a measure of the intensity asymmetry.

In a known method using a multi-grating target (with gratings of pitch p) such as the target illustrated in Figure 4, the overlay OV can be determined, for example, using the following equation:

$$OV = \frac{p}{2\pi} \tan^{-1}\left( \tan\left(\frac{2\pi d}{p}\right) \left( \frac{\left(I^{+1}_{+d} - I^{-1}_{+d}\right) + \left(I^{+1}_{-d} - I^{-1}_{-d}\right)}{\left(I^{+1}_{+d} - I^{-1}_{+d}\right) - \left(I^{+1}_{-d} - I^{-1}_{-d}\right)} \right) \right)$$

$$\cong d \frac{A_{+d} + A_{-d}}{A_{+d} - A_{-d}} \qquad \text{(Equation 1)}$$

where:

- $I^{+1}_{+d}$ is the +1st diffraction order from positive bias target (e.g., intensity value);

- $I^{-1}_{+d}$ is the -1st diffraction order from positive bias target;

- $I^{+1}_{-d}$ is the +1st diffraction order from negative bias target;

- $I^{-1}_{-d}$ is the -1st diffraction order from negative bias target;

- $A_{+d} = I^{+1}_{+d} - I^{-1}_{+d}$ ; (e.g., asymmetry in the +1st and -1st intensities from positive bias target); and

- $A_{-d} = I^{+1}_{-d} - I^{-1}_{-d}$ , (e.g., asymmetry in the +1st and -1st intensities from negative bias target).

Measurements using a metrology apparatus such as that illustrated in Figure 3(a), e.g., dark-field measurements on targets such as illustrated in Figure 4, are known to suffer from measurement field (or spot) inhomogeneity. In the presence of spot inhomogeneity, the measurement spot which illuminates the target is not perfectly homogeneous, such that some parts of the target receive more light than others. This can be measured as an asymmetry and therefore interpreted as a variation of the parameter of interest (e.g., overlay in the case of μDBO metrology or focus/dose in the case of diffraction-based focus (DBF) or dose metrology) instead of as a simple intensity variation. This means that the measured (overlay/focus/dose) value is impacted by the location of the grating within the measurement field. Both the spatial layout of the measured target and small inaccuracies in placing the targets at the center of the illumination spot contribute to errors due to spot inhomogeneity.

Each measurement of a grating is typically an intensity measurement. Each intensity measurement may be of the intensity of a single diffraction order (e.g., the +1 or -1 order) of radiation diffracted by the grating. Each of the +1 diffraction order and -1 diffraction order is imaged to obtain respective dark-field Fourier plane images, often conventionally referred to as respectively a normal image and a complementary image. In the absence of overlay and bias (and any other process asymmetry), a target is a simple grating which diffracts an incident beam to create +1 and -1 order beams (other diffraction orders and the zeroth order will either be blocked or not captured). Using such a single grating target, the properties of the illumination and optics can be measured by looking at the normal and complementary images, where each image is a 2D map of signal strength S(X,Y) as measured by the camera. It can be shown that the impact of measurement field non-homogeneity is an offset between intensity measurement at different locations within the measurement field.

Spot inhomogeneity or imperfect "spot homogeneity" can be divided into two components. A first component is sometimes referred to as common spot homogeneity (CSH). This is the component which will be the same for the normal image N and complementary image C. The second component is sometimes referred to as differential spot homogeneity (DSH), and is the component which differs between the normal image N and complementary image C.

More generally, the measurements of the normal image N and complementary image C can be decomposed into four components: an average signal component, a mean asymmetry component, a common spot homogeneity component and a differential spot homogeneity component. The average signal comprises the average of the full normal and complementary images and is typically not used. The mean asymmetry can be determined by considering the averaged normal image compared with the averaged complementary image (this does not consider the field distribution). This mean asymmetry component can be corrected by wafer rotation averaging; i.e., averaging the measurement illustrated by Figure 3(b)/(d) and the measurement illustrated by Figure 3(c)/(e), which is a commonly used technique for tool-induced shift (TIS) correction.

The common spot homogeneity (CSH) component describes what is visible in the field image, specifically the part that is the same for the normal and complementary images. This has only a very small impact on measurement accuracy and may be ignored (although this common spot homogeneity may be partially corrected by the methods disclosed herein).

The differential spot homogeneity (DSH) component is the part of the field homogeneity that is different for the normal N and complementary C images. It is correction for this component which is the primary focus of this disclosure. Without correction for this differential spot homogeneity component, the measured parameter of interest will be impacted by the properties of the measurement beam. This has a direct negative impact on tool-to-tool matching (i.e., minimizing measurement variation between different metrology tools).

From the normal image N and the complementary image C, a common spot homogeneity image *CSH* related to common spot homogeneity and a differential spot homogeneity image *DSH* related to differential spot homogeneity, can be computationally determined such that:

$$N = CSH + DSH$$

$$C = CSH - DSH$$

A known correction method for spot inhomogeneity correction which corrects for this DSH component comprises measuring the spot homogeneity distribution on a fiducial in a calibration step to determine a correction, such that the correction can be subsequently subtracted from μDBO images from targets measured in a production setting. However, this method is unreliable; while it sometimes improves matching performance, in other times it actually worsens it. This is due to the differences between fiducial and target. For example, the far field reflectivity profile (or diffraction efficiency) can be significantly different for targets with respect to the fiducial. Also, the fiducial comprises a single layer which induces no asymmetry in the strength of the diffracted orders, while a metrology target will induce such an asymmetry due to bias and overlay (or focus induced asymmetry).

Another known method for spot inhomogeneity correction is described in WO2016202674A1, which is incorporated herein by reference. In this method, the target is measured repeatedly in sequence with the target shifted within the measurement spot between the measurements, thereby sequentially placing each of the target's component sub-targets at the same location in the beam. This has the drawback that four additional measurements need be performed (one for each of the sub-targets) per wafer rotation/orientation. Additionally, any temporal disturbances during the sequence of measurements provide an additional error source.

It is therefore proposed to address the issue of spot inhomogeneity, and more specifically differential spot inhomogeneity (DHS), by providing a substrate comprising: at least one first metrology target for measuring a parameter of interest in at least one measurement direction, each said at least one first metrology target comprising at least one first-type sub-target and at least one second-type sub-target (e.g., one first-type sub-target and at second-type sub-target per measurement direction); and at least one second metrology target, wherein each said second metrology target is similar to said each first metrology target, but with the first-type sub-targets swapped in position with the second-type sub-targets in at least one measurement direction (e.g., per measurement direction).

As such, where there is a first-type sub-target of a first measurement direction in a first position (e.g., a particular quarter) of each first metrology target, each second metrology target will have a second-type sub-target of the first measurement direction in that first position. Similarly, where there is a second-type sub-target of a first measurement direction in a second position of each first metrology target, each second metrology target will have a first-type sub-target of the first measurement direction in that second position. The same may apply for first-type and second-type sub-targets of a second measurement direction which may occupy respectively third and fourth positions in each first metrology target and therefore respectively fourth and third positions in each second metrology target.

Where the parameter of interest is overlay, the first-type sub-target may comprise a first imposed overlay bias and the second-type sub-target may comprise a second imposed overlay bias. The first imposed overlay bias and second imposed overlay bias may be equal in magnitude and opposite in direction. Alternatively, the first-type sub-target may comprise a first grating having a first pitch in a first layer and a second grating having a second pitch in a second layer and the second-type sub-target may comprise the first grating having the first pitch in the second layer and the second grating having the second pitch in the first layer.

Where the parameter of interest is focus, the first-type sub-target may comprise a normal focus sub-target and the second-type sub-target may comprise a mirror focus sub-target, the mirror focus sub-target being a mirrored representation of the normal focus sub-target.

The metrology target may comprise at least one first-type sub-target per measurement direction and at least one second-type sub-target per measurement direction. Where this is the case, the swapping of first-type and second-type sub-targets may be done per direction, or for only one of the directions.

The measurement directions may comprise two perpendicular directions of the substrate plane. Such a target may comprise a 2x2 array of said sub-targets. The sub-targets may be arranged such that sub-targets for measuring the parameter of interest in the same measurement direction are opposed diagonally in the 2x2 array (e.g., such that the second metrology target is a 180 degree rotation of the first metrology target).

Figure 6 illustrates an example metrology target arrangement 631 according to concepts described herein, in the context of µDBO metrology. A first metrology target 631a comprises a first-type sub-target 632, in this case a sub-target with first bias +d, for measuring overlay in a first direction (e.g., the X-direction) of the substrate plane, a first-type sub-target 633 (i.e., comprising the first bias +d) for measuring overlay in a second direction (e.g., the Y-direction) of the substrate plane, a second-type sub-target 634, in this case a sub-target with second bias -d, for measuring overlay in the first direction, and a second-type sub-target 635 (i.e., comprising the second bias -d) for measuring overlay in the second direction. This metrology target is essentially similar to that illustrated in Figure 4.

The metrology target arrangement 631 also comprises a second metrology target 631b for which the first-type sub-targets are swapped in position with the second-type sub-targets for each of the measurement directions. Note, however, that this swapping may optionally be done for only one of the measurement directions, or the target may comprise only a pair of sub-targets (one first-type and one second-type) for metrology in only a single measurement direction.

As such, the second metrology target 631b comprises a second-type (-d) sub-target 636 for first direction (X) metrology in the position which the first-type (+d) sub-target 632 for first direction (X) metrology occupies in the first metrology target 631a. A second-type (-d) sub-target 637 for second direction metrology (Y) is in the position occupied by the first-type sub-target (+d) 633 for second direction metrology (Y) in the first metrology target 631a. Similarly, a first-type (+d) sub-target 638 for first direction (X) metrology is in the position occupied by the second-type (-d) sub-target 634 for first direction (X) metrology in the first metrology target 631a and a first-type (+d) sub-target 639 for second direction metrology (Y) is in the position occupied by the second-type (-d) sub-target 635 for second direction metrology (Y) in the first metrology target 631a.

Therefore, sub-targets 636, 638, relating to the first measurement direction, are swapped in position compared to sub-targets 632, 634. Similarly, sub-targets 637, 639, relating to the second measurement direction, are swapped in position compared to sub-targets 633, 635. Note that where the (e.g., first) metrology target is arranged in this way, with the sub-targets relating to the same measurement direction being diagonally opposed, the second metrology target comprises a 180 rotation of the first metrology target (this is only an observation for this particular arrangement, for other arrangements this will not be the case).

The method may comprise providing additional metrology targets, e.g., one or more second metrology targets, for example each in the vicinity of a respective first metrology target. For example, all the first metrology targets may comprise a corresponding second metrology target within its vicinity (e.g., sufficiently close such that overlay may be considered to be substantially the same, or any difference minimized, for the two targets).

Alternatively, the method may comprise using the same number of targets as would have been used without using the concepts disclosed herein, such as targets of the type of first metrology target 631a, but with one or more of the first metrology targets replaced with second metrology targets with sub-targets swapped in position (target 631b if the first metrology target is 631a). For example, a method (e.g., any known method) may be used to determine a sampling scheme (or measurement scheme) for a particular use case, and therefore a number of measurement locations to be probed by the beam spot. The method may then divide the measurement locations such that one or more measurement locations comprise second metrology targets, with the remainder of the measurement locations of the sampling scheme comprising first metrology targets.

A metrology method may comprise measuring such a substrate as disclosed herein, so as to correct for spot inhomogeneity (e.g., specifically differential spot inhomogeneity (DSH)). Such a method may comprise determining a correction for the metrology data obtained from measuring the targets from a comparison of one or more first measured values from said at least one first measurement target and one or more second measured values from said at least one second measured target. Such a method may comprise comparing an average (or other combination) of the first measurement values and an average (or other combination) of the second measurement values. The averaging/combining may comprise averaging/combining the corresponding measurement signals (e.g., intensities), e.g., per sub-target type or averaging/combining the determined parameter of interest values. The correction can then be applied to each of the (first and second) measurement values to determine the parameter of interest.

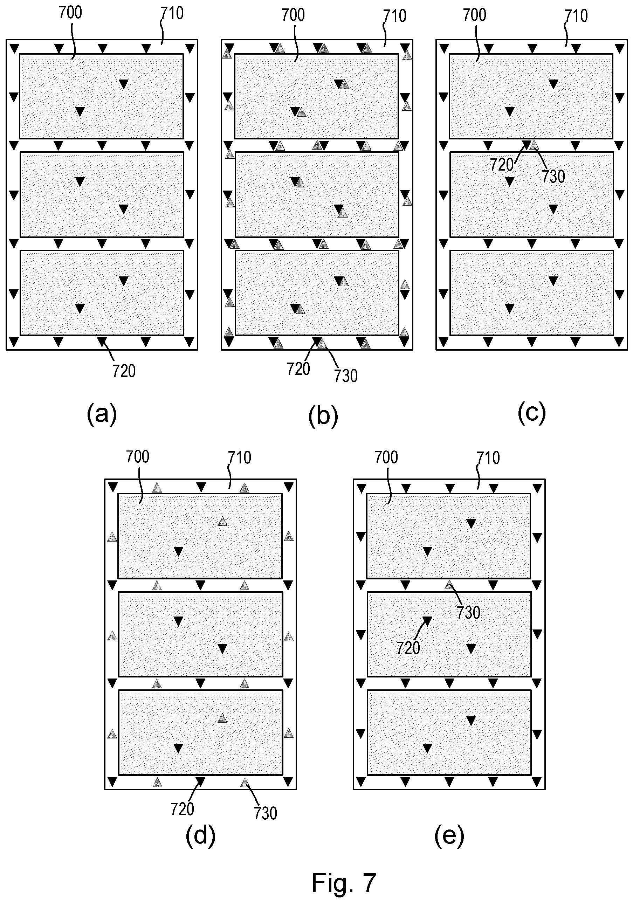

Alternatively, the comparison may be made from subsets of metrology targets comprising at least one first metrology target and at least one second metrology target. Such subsets may comprise metrology target pairs comprising a first metrology target and a second metrology target. The metrology target pairs may be paired (or subsets grouped) on their proximity on the substrate, whether purposely exposed in proximity such as in the Figure 7(b) and 7(c) examples described below) or otherwise (e.g., as in the examples of Figure 7(d) and 7(e) described below). Alternatively, metrology target pairs may be paired (or subsets grouped) based on a comparison and/or prediction of parameter of interest values, e.g., to minimize predicted parameter of interest variation within each of the pairs/groups. The predicted parameter of interest variation may be based on a parameter of interest fingerprint (e.g., spatial distribution); for example, by aligning the direction of the pairs to be mainly orthogonal (e.g., to minimize correlation) to the direction of the gradient of the fingerprint. A correction may be determined for each pair and/or the parameter of interest determined for each pair which is corrected for the effect of spot inhomogeneity.

In some embodiments, there may be only one second metrology target (or a small number of second metrology targets), and the correction determined for only a single pair (or small number of metrology target pairs and averaged or applied per substrate region), such that the correction can be applied to measurement values for the other metrology targets.

Figure 7(a) illustrates a purely exemplary present reticle arrangement or exposure field arrangement comprising one or more product areas 700, one or more scribe areas (scribe lanes) 710 and a plurality of metrology targets 720 (in the case of overlay, the full target will be formed overlaid in two or more layers). The number, shape and arrangement of product areas 700, scribe lanes 710 and metrology targets 720 is purely illustrative and will differ from product to product.

Figures 7(b)-7(e) illustrate purely exemplary target arrangements for implementing the concepts disclosed herein. In Figure 7(b), there is provided a respective second metrology target 730 in the vicinity of each of the metrology targets (i.e., first metrology targets) 720 of Figure 7(a). For such an arrangement, the measurement value for each metrology target pair may be determined as an average of the first metrology target 720 and second metrology target 730 at each location (e.g., optionally for both wafer orientations, i.e., 0 and 180 degrees).

Alternatively the respective measurement value for the first metrology target 720 and second metrology target 730 may be compared per pair (e.g., with one measured at the opposite orientation to the other) to determine a correction. The correction can then be applied to the measured value for each of the targets of the pair. In this example, there will be two separate parameter of interest values determined per measurement location. This can improve robustness and/or provide opportunity to correct for other effects such as nuisance target asymmetries.

Such an arrangement as shown in Figure 7(b) will provide the best correction, since the difference between the two targets (e.g., in terms of distance and/or parameter of interest variation) will be the smallest for all locations. However, this has the drawback of requiring twice as many targets and therefore twice the area and measurement time for metrology. This limits the desirability of such an approach.

Figure 7(c) illustrates an arrangement where only a single second metrology target 730 has been added in the vicinity of one of the first metrology targets 720. The single second metrology target 730 may be added adjacent to any one of the first metrology targets 720, e.g., it may be paired with a first metrology target 720 other than the one illustrated. A metrology method for such an arrangement may comprise comparing the measurement value of the second metrology target 730 with the measurement value of the adjacent (nearest) first metrology target 720 (e.g., at different orientations 0, 180 degrees). The difference between the measurement values will be twice the error attributable to differential spot inhomogeneity. As such, a correction comprising half of the error may be applied to respective measurement values of each of the other targets.

It can be appreciated that Figures 7(b) and 7(c) represent extreme examples of the same basic idea and that any intermediate arrangement is possible and can be envisaged; e.g., where two or more second metrology targets 730 are added, with each of the second metrology targets 730 being paired (in the vicinity of) a respective first metrology target 720. In such an arrangement, the correction may be averaged over the pairs or a respective correction may be determined per substrate region (e.g., for all targets nearest each respective target pair).

Such an arrangement, particularly where there is only a single target, relies on the effect of the layer having significant homogeneity (low location dependency) for good correction efficiency. This will depend on the layer properties.

It can be appreciated that even the example of Figure 7(c) requires additional substrate area to be reserved for metrology. Figure 7(d) and 7(e) illustrated proposed target arrangements which require no additional metrology real estate compared to the conventional example of Figure 7(a). These arrangements are based on the observation that both the first metrology targets 720 and second metrology targets 730 are each targets from which the parameter of interest can be individually measured. Therefore, instead of adding additional targets, one or more of the targets (e.g., first metrology targets 720) of a proposed sampling scheme or measurement scheme can be replaced with a second metrology target 730.

In Figure 7(d), the metrology targets are evenly split between first metrology targets and second metrology targets (i.e., there is an equal number of each). In other examples, between 20% and 80%, between 30% and 70%, between 40% and 60%, between 45% and 55%, or (as illustrated) 50% of the targets of the proposed sampling scheme may comprise the second metrology targets, with the remaining targets comprising the first metrology targets. The first metrology targets and second metrology targets may each be distributed fairly evenly over the field. In other examples, there may be less than 20% of the targets of the proposed sampling scheme comprising the second metrology targets, for instance 5 or 10%, depending on the total number of targets.

In this arrangement, the difference between the (e.g., averaged) first metrology data from the first metrology targets 720 and the (e.g., averaged) second metrology data from the second metrology targets 730 can be used to determine a correction for each of the targets. This difference will be twice the error being corrected. The correction therefore may be determined as half of the difference. The correction should be applied in the opposite direction for the first metrology targets 720 and second metrology targets 730, e.g., added to the first metrology data and subtracted to the second metrology data or *vice versa,* i.e., such that the values are brought values closer together. This is because the second metrology targets 730 are the reverse of the first metrology targets 720.

Alternatively, pairs of one first metrology target and one second metrology target may be determined, e.g., that are closest together in terms of distance and/or in terms of an expected value for the parameter of interest and/or a measured property of the measurement targets (e.g., by separate measurement, e.g., such as pupil images). These measurement values may be averaged over the target pairs, or a correction value determined as half the difference between the measurement values of each pair. The per-pair correction value can then be applied to the measurement values of that pair, again in different directions (one added, one subtracted to bring the values closer together).

Figure 7(e) is similar to Figure 7(c), but with the single second metrology target 730 replacing one of the first measurement targets 720, rather than being placed in the vicinity of a first metrology target 720. The first metrology target 720 replaced may differ from that shown. The measurement value for the second metrology target 730 can be compared with that of the nearest first measurement target 720 (e.g., in terms of distance and/or predicted parameter of interest value). The measured values for all the metrology targets can be corrected with half of this difference (applying the correction to the second metrology target 730 in the opposite direction to the first metrology targets 720).

The methods disclosed herein may be applicable to other overlay target types and overlay methods. One such method may comprise continuous DBO (cDBO), where the gratings in each layer have different pitches, the order of the gratings being reversed in two complementary targets (e.g., per direction). In each case, the proposed methods may be employed to retrieve the phase of each diffraction order. In such an example, the first-type sub-target may comprise the "M-type" sub-target which comprises the smaller pitch in the top layer and the second-type sub-target may comprise the "W-type" sub-target which comprises the larger pitch in the top layer.

The target arrangements illustrated and methods described have been those designed for measurement of overlay. However the concepts herein may also be applicable to target arrangements designed for measurement of another parameter of interest. For example, a focus arrangement (e.g., formed with regions having a focus sensitive asymmetry) can also benefit. Focus targets typically comprise features which have an asymmetry that has a (e.g., monotonic) relationship with scanner focus during their formation. This may be achieved, for example, by providing a grating or gratings with individual line features, where the line features each having sub-resolution features (assist features) along only one of its edges. These sub-resolution features cannot be exposed as they are too small, however their presence affects the formation of the edge of the line feature which depends on focus, thereby providing a focus dependent asymmetry. Therefore, by measuring intensity asymmetry from the target (e.g., in a similar manner to μDBO) the actual exposure focus during the target exposure can be inferred. Because of the similarity of the measurement strategy (intensity asymmetry, i.e., a comparison of the strength of +1 and -1 orders), and the fact that focus targets typically comprise two or more sub-targets (e.g., two sub-targets per measurement direction), the correction methods disclosed herein are equally applicable to DBF metrology. In such an example, a first-type sub-target may comprise a normal sub-target and a second-type sub-target may comprise a mirror sub-target (i.e., the mirror sub-target is a mirrored or reversed representation of a normal sub-target). As such, per direction, in the at least one second target (reverse target), the mirrored sub-target may take the place of the normal sub-target compared to the at least one first target and *vice versa.*

In all embodiments, the substrates or a subset thereof can be measured at two wafer rotations (e.g, 0 and 180 degrees) and averaged. As such, any of the corrections disclosed herein may be averaged over these wafer orientations. This is purely optional to achieve the differential spot inhomogeneity correction (it provides additional corrections).

It can be appreciated that all the specific arrangements shown are purely examples and there is a near infinite number of possible target arrangements which fall within the scope of the present disclosure. For example, a target arrangement may only comprise target regions for measuring in only a single direction. Also spacing can be added between the pads to counter crosstalk and/or parallax issues.

In association with the physical grating structures of the targets realized on substrates and patterning devices, an embodiment may include a computer program containing one or more sequences of machine-readable instructions describing methods of measuring targets on a substrate and/or analyzing measurements to obtain information about a lithographic process. This computer program may be executed for example within unit PU in the apparatus of Figure 3(a) and/or the control unit LACU of Figure 2. There may also be provided a data storage medium (e.g., semiconductor memory, magnetic or optical disk) having such a computer program stored therein. Where an existing metrology apparatus, for example of the type shown in Figure 3(a), is already in production and/or in use, the invention can be implemented by the provision of updated computer program products for causing a processor to perform the steps necessary to calculate the overlay error.

The program may optionally be arranged to control the optical system, substrate support and the like to perform the steps necessary to calculate the overlay error for measurement of asymmetry on a suitable plurality of targets.

Therefore, disclosed is a target arrangement suitable for metrology of a lithographic process comprising at least two targets positioned within the target arrangement such that the target arrangement has a symmetry upon rotation. The at least two targets may be positioned within the target arrangement such that a measured property of the at least two target has a symmetry upon rotation. Also disclosed is a method to measure a parameter of a lithographic process comprising measuring at least two targets of a metrology target arrangement by illuminating the targets with radiation and detecting the radiation scattered by the targets and determining a property in the measurement of the targets wherein the property has a symmetry upon rotation.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), A well A particle beams, such A ion beams or electron beams.

The term "lens", where the context allows, may refer to any one or combination of various types of components, including refractive, reflective, magnetic, electromagnetic and electrostatic components.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

Further embodiments according to the invention are described in below numbered clauses:

1. A substrate comprising:

one or more first metrology targets for measuring a parameter of interest in one or more measurement directions, each said one or more first metrology targets comprising at least one first-type sub-target and at least one second-type sub-target; and

one or more second metrology targets, wherein each said second metrology target is similar to each said first metrology target, but with the first-type sub-targets swapped in position with the second-type sub-targets of the same measurement direction for at least one measurement direction of said one or more measurement directions.

2. A substrate according to clause 1, wherein the parameter of interest is overlay.

3. A substrate according to clause 2, wherein the first-type sub-target comprises a first imposed overlay bias and the second-type sub-target comprises a second imposed overlay bias.

4. A substrate according to clause 3, wherein the first imposed overlay bias and the second imposed overlay bias are equal in magnitude and opposite in direction.

5. A substrate according to clause 2, wherein the first-type sub-target comprises a first grating having a first pitch in a first layer and a second grating having a second pitch in a second layer and the second-type sub-target comprises the first grating having the first pitch in the second layer and the second grating having the second pitch in the first layer.

6. A substrate according to clause 1, wherein the parameter of interest is focus.

7. A substrate according to clause 6, wherein the first-type sub-target comprises a normal focus sub-target and the second-type sub-target comprises a mirror focus sub-target, the mirror focus sub-target being a mirrored representation of the normal focus sub-target.

8. A substrate according to any preceding clause, wherein each first metrology target and each second metrology target comprises at least one first-type sub-target and at least one second-type sub-target for each of a first measurement direction and a second measurement direction.

9. A substrate according to clause 8, wherein the second metrology targets comprise the first-type sub-targets swapped in position with the second-type sub-targets of the same measurement direction for each of the first measurement direction and a second measurement direction, compared to the first metrology targets.

10. A substrate according to any preceding clause, wherein each first metrology target and each second metrology target comprises a 2x2 array of said sub-targets.

11. A substrate according to any preceding clause, wherein each measurement location of a measurement scheme comprises a respective said first measurement target; and

said one or more second metrology targets is/are provided in addition to the first metrology target respectively at one or more of said measurement locations of the measurement scheme.

12. A substrate according to clause 11, wherein each one or more second metrology targets is/are in the vicinity of a respective first metrology target.

13. A substrate according to clause 11 or 12, wherein each said one or more first metrology targets comprises a respective second metrology target within its vicinity.

14. A substrate according to any of clauses 1 to 10, wherein said one or more first metrology targets and said one or more second metrology targets are arranged such that each measurement location of a measurement scheme comprises only one of a first metrology target or a second metrology target.

15. A substrate according to clause 14, comprising one or more first metrology targets and only one second metrology target.

16. A substrate according to clause 14, wherein the second metrology targets comprise between 20% and 80% of the total number of first metrology targets and second metrology targets.

17. A substrate according to clause 14, wherein the number of first metrology targets and second metrology targets are equal.

18. A substrate according to any preceding clause, comprising a plurality of first measurement targets.

19. A metrology method comprising:

obtaining metrology data relating to a substrate comprising one or more first metrology targets for measuring a parameter of interest in at one or more measurement directions, each said one or more first metrology targets comprising at least one first-type sub-target and at least one second-type sub-target;

and one or more second metrology targets, wherein each said second metrology target is similar to each said first metrology target, but with the first-type sub-targets swapped in position with the second-type sub-targets of the same measurement direction for at least one measurement direction of said one or more measurement directions, said metrology data comprising first metrology data from said one or more first metrology targets and second metrology data from said one or more second metrology targets; and

determining a parameter of interest from the metrology data;

wherein said determining a parameter of interest comprises correcting said parameter of interest from an effect of measurement field inhomogeneity from a comparison and/or combination of one or more first measured values comprised within the first metrology data and one or more second measured values comprised within the second metrology data.

20. A metrology method according to clause 19, wherein said correcting the parameter of interest comprises:

determining a correction for the metrology data from a comparison of a combination of the first metrology data and a combination of the second metrology data; and
applying the correction to said metrology data prior to determining the parameter of interest.

21. A metrology method according to clause 20 wherein each said combination comprises an average.

22. A metrology method according to clause 19, wherein said correcting the parameter of interest comprises:

determining a respective correction for each of one or more metrology target pairs, each metrology target pair comprising one said first metrology target and one said second metrology target,
wherein each correction is determined for each metrology target pair from a comparison of a first measurement value from the first metrology target of the metrology target pair and a second measurement value from the second metrology target of the metrology target pair.

23. A metrology method according to clause 22, wherein there are an equal number of first metrology targets and second metrology targets; and
the method comprises correcting said parameter of interest individually for each said first metrology target and/or each said second metrology target.

24. A metrology method according to clause 22, wherein the substrate comprises a single second metrology target forming a metrology target pair with a corresponding first metrology target; and the method comprises:

determining a correction from a comparison of a second measurement value from the second metrology target and a first measurement value from the corresponding first metrology target; and
applying the correction to said metrology data prior to determining the parameter of interest.

25. A metrology method according to clause 23 or 24, wherein each said metrology target pair comprises a second metrology target and a first metrology target which are closest according to at least one criterion.

26. A metrology method according to clause 25, wherein the at least one criterion comprises one or more of physical distance and/or respective estimated values for the parameter of interest and/or measured metrology target properties.

27. A metrology method according to clause 26, wherein the at least one criterion is assessed based on an expected or measured spatial distribution for the parameter of interest.

28. A metrology method according to any of clauses 19 to 27, wherein said parameter of interest is overlay, exposure focus or exposure dose.

29. A metrology method according to any of clauses 19 to 28, comprising determining a correction for a lithographic process from the determined parameter of interest.

30. A metrology method according to any of clauses 19 to 29, wherein said metrology data comprises data measured from the substrate at two different orientations.

31. A metrology method according to any of clauses 19 to 30, comprising measuring said substrate to obtain said metrology data.

32. A metrology method according to any of clauses 19 to 31, wherein each first metrology target and each second metrology target comprises at least one first-type sub-target and at least one second-type sub-target for each of a first measurement direction and a second measurement direction; and wherein said determining a parameter of interest and correcting said parameter of interest comprises determining parameter of interest and correcting the parameter of interest for each of the first measurement direction and second measurement direction.

33. A computer program comprising program instructions operable to cause a metrology apparatus to perform the method according to any of clauses 19 to 32, when run on a suitable apparatus.

34. A non-transient computer program carrier comprising the computer program of clause 33.

35. A processing arrangement comprising:

the non-transient computer program carrier of clause 34; and
a processor operable to run said computer program.

36. A metrology apparatus comprising the processing arrangement of clause 35.

37. One or more patterning devices comprising features for forming at least one first metrology target and at least one second metrology target, thereby being configured to produce the substrate according to any of clauses 1 to 18 when used to pattern a substrate in one or more exposures in one or more layers.

**Claims**

1. A substrate comprising:

   one or more first metrology targets for measuring a parameter of interest in one or more measurement directions, each said one or more first metrology targets comprising at least one first-type sub-target and at least one second-type sub-target; and
   one or more second metrology targets, wherein each said second metrology target is similar to each said first metrology target, but with the first-type sub-targets swapped in position with the second-type sub-targets of the same measurement direction for at least one measurement direction of said one or more measurement directions.

2. A substrate as claimed in claim 1, wherein the parameter of interest is overlay.

3. A substrate as claimed in claim 2, wherein the first-type sub-target comprises a first imposed overlay bias and the second-type sub-target comprises a second imposed overlay bias.

4. A substrate as claimed in claim 3, wherein the first imposed overlay bias and the second imposed overlay bias are equal in magnitude and opposite in direction.

5. A substrate as claimed in claim 2, wherein the first-type sub-target comprises a first grating having a first pitch in a first layer and a second grating having a second pitch in a second layer and the second-type sub-target comprises the first grating having the first pitch in the second layer and the second grating having the second pitch in the first layer.

6. A substrate as claimed in claim 1, wherein the parameter of interest is focus.

7. A substrate as claimed in claim 6, wherein the first-type sub-target comprises a normal focus sub-target and the second-type sub-target comprises a mirror focus sub-target, the mirror focus sub-target being a mirrored representation of the normal focus sub-target.

8. A substrate as claimed in any preceding claim, wherein each first metrology target and each second metrology target comprises at least one first-type sub-target and at least one second-type sub-target for each of a first measurement direction and a second measurement direction.

9. A substrate as claimed in claim 8, wherein the second metrology targets comprise the first-type sub-targets swapped in position with the second-type sub-targets of the same measurement direction for each of the first measurement direction and a second measurement direction, compared to the first metrology targets.

10. A substrate as claimed in any preceding claim, wherein each first metrology target and each second metrology target comprises a 2x2 array of said sub-targets.

11. A substrate as claimed in any preceding claim, wherein each measurement location of a measurement scheme comprises a respective said first measurement target; and
said one or more second metrology targets is/are provided in addition to the first metrology target respectively at one or more of said measurement locations of the measurement scheme.

12. A substrate as claimed in claim 11, wherein each one or more second metrology targets is/are in the vicinity of a respective first metrology target.

13. A substrate as claimed in claim 11 or 12, wherein each said one or more first metrology targets comprises a respective second metrology target within its vicinity.

14. A substrate as claimed in any of claims 1 to 10, wherein said one or more first metrology targets and said one or more second metrology targets are arranged such that each measurement location of a measurement scheme comprises only one of a first metrology target or a second metrology target.

15. A metrology method comprising:

obtaining metrology data relating to a substrate comprising one or more first metrology targets for measuring a parameter of interest in at one or more measurement directions, each said one or more first metrology targets comprising at least one first-type sub-target and at least one second-type sub-target;

and one or more second metrology targets, wherein each said second metrology target is similar to each said first metrology target, but with the first-type sub-targets swapped in position with the second-type sub-targets of the same measurement direction for at least one measurement direction of said one or

more measurement directions, said metrology data comprising first metrology data from said one or more first metrology targets and second metrology data from said one or more second metrology targets; and

determining a parameter of interest from the metrology data;

wherein said determining a parameter of interest comprises correcting said parameter of interest from an effect of measurement field inhomogeneity from a comparison and/or combination of one or more first measured values comprised within the first metrology data and one or more second measured values comprised within the second metrology data.

Fig. 1

Fig. 2

Fig. 3

Fig. 4

Fig. 5

Fig. 6

Fig. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2009078708 A
- WO 2009106279 A
- US 20110027704 A
- US 20110043791 A
- US 20120242970 A
- US 2010201963 A1
- US 2011102753 A1
- WO 2016202674 A1